Europäisches Patentamt

European Patent Office

Office européen des brevets

(19)

(11) **EP 1 365 511 A1**

## (12) DEMANDE DE BREVET EUROPEEN

(43) Date de publication:
**26.11.2003 Bulletin 2003/48**

(51) Int Cl.$^7$: **H03K 17/08**

(21) Numéro de dépôt: **03354026.1**

(22) Date de dépôt: **21.03.2003**

(84) Etats contractants désignés:
**AT BE BG CH CY CZ DE DK EE ES FI FR GB GR HU IE IT LI LU MC NL PT SE SI SK TR**
Etats d'extension désignés:
**AL LT LV MK RO**

(30) Priorité: **22.03.2002 FR 0203624**

(71) Demandeur: **STMicroelectronics S.A.**
**92120 Montrouge (FR)**

(72) Inventeurs:
- **Bienvenu, Philippe**
  **13190 Allauch (FR)**
- **Pavlin, Alain**
  **13540 Puyricard (FR)**

(74) Mandataire: **Thibon, Laurent**
**Cabinet Michel de Beaumont**
**1, rue Champollion**
**38000 Grenoble (FR)**

### (54) Commande d'une charge de puissance

(57)    L'invention concerne un circuit (20) de commande en alimentation d'une charge (1), ledit circuit comprenant un interrupteur intégré (23) et son circuit de commande dans un même boîtier, et des moyens (26) propres à asservir le niveau du courant traversant ledit interrupteur en fonction d'une différence de température instantanée entre l'interrupteur et son environnement

Fig 3

**Description**

La présente invention concerne, de façon générale, la commande de l'alimentation d'une charge de puissance (dont la puissance en fonctionnement est comprise entre quelques Watts et une centaine de Watts). L'invention concerne plus précisément la commande d'un interrupteur de puissance destiné à alimenter une charge. Il s'agit, par exemple, dans l'industrie automobile, de phares, de dispositifs de dégivrage, de moteurs tels que ceux destinés à commander des vitres ou des essuie-glaces, etc. Dans ce cas, l'interrupteur est généralement commandé en commutation (en tout ou rien). Selon un autre exemple d'application, l'interrupteur est commandé en régime linéaire, par exemple, pour asservir la tension fournie à une charge.

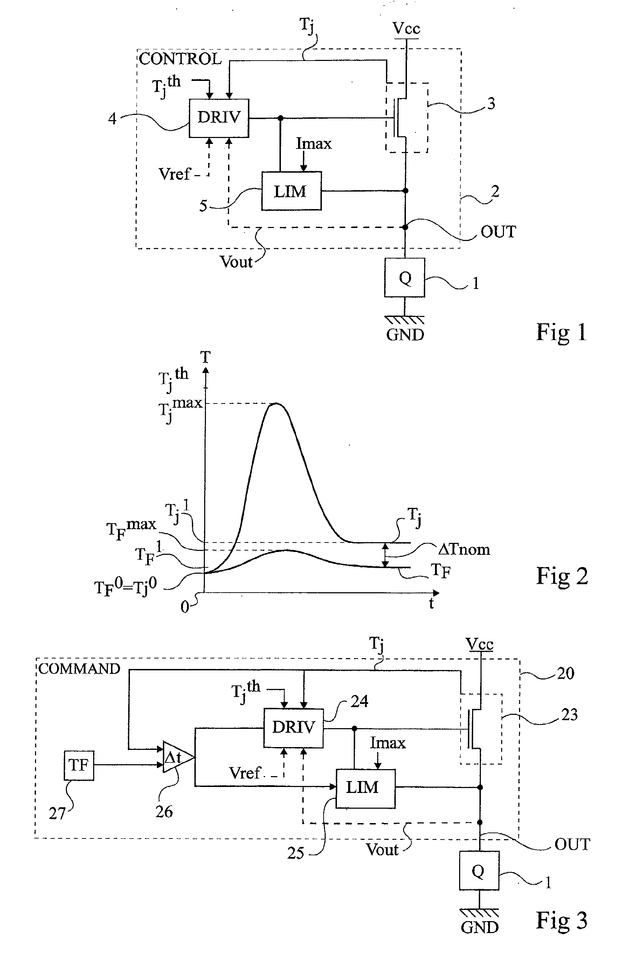

La figure 1 illustre, de façon partielle sous forme de blocs fonctionnels, un exemple classique de circuit 2 (CONTROL) de commande d'une charge de puissance (Q) 1. Le circuit 2 est connecté en série avec la charge 1, entre deux lignes d'alimentation respectivement haute Vcc et basse ou masse GND. Le circuit de commande 2 comprend essentiellement un interrupteur de puissance 3, intercalé entre la ligne d'alimentation haute Vcc et une borne de sortie OUT du circuit 2. La borne OUT est destinée à être connectée à une première borne d'alimentation de la charge 1, une autre borne de la charge 1 étant à la masse GND. Une configuration inverse (charge connectée entre la ligne Vcc et la borne OUT du circuit 2) est également possible. L'interrupteur 3 est alors relié à la masse. L'interrupteur 3 est un interrupteur commandable, typiquement un transistor MOS, associé à un circuit pilote (DRIV) 4. Le circuit 4 fournit un signal de commande de l'interrupteur 3.

Appliqué à une commande en régime linéaire, le circuit 4 sert à réguler, aux bornes de la charge 1, une tension nominale recherchée. Pour ce faire, le circuit 4 compare la tension courante Vout sur la borne de sortie OUT du circuit de commande 2 à une valeur de référence Vref.

Appliqué à une commande en commutation, les liaisons (illustrées en pointillés en figure 1) du circuit 4 à la tension Vref et à la borne de sortie OUT sont omises. Le circuit 4 reçoit par contre un signal de consigne (non représenté) d'allumage ou d'extinction de la charge 1. Cette consigne est généralement également présente pour une commande en régime linéaire.

Un circuit de commande tel qu'illustré en figure 1 comporte deux types de protections de l'interrupteur 3.

Une première protection est une protection en courant afin de limiter le courant passant dans l'interrupteur 3 et/ou dans le câblage externe au circuit 2, à une valeur tolérable en cas de court-circuit, c'est-à-dire pour le cas où la charge 1 se retrouve en court-circuit engendrant potentiellement un courant susceptible de détruire l'interrupteur 3 et/ou le câblage externe. Pour cela, un limiteur de courant (LIM) 5 est placé entre la borne de commande de l'interrupteur 3 et la borne de sortie OUT, et est actif quand le courant dans l'interrupteur 3 dépasse un seuil Imax prédéterminé.

Une deuxième protection est une protection thermique afin de limiter l'échauffement de l'interrupteur de puissance 3. Pour cela, le circuit pilote 4 inclut un comparateur de la température courante (en pratique, une tension représentative de la température) de l'interrupteur 3 par rapport à un seuil prédéterminé $T^{th}_j$. La température courante $T_j$ de l'interrupteur 3 est fournie par un capteur (non représenté) prévu dans l'interrupteur. Quand l'interrupteur surchauffe, le circuit 4 modifie sa commande. Soit il ouvre l'interrupteur (commutation), soit il en réduit la consigne de commande (régime linéaire).

L'efficacité des protections ci-dessus dépend de la capacité thermique du circuit (plus précisément de l'ensemble boîtier-puce), c'est-à-dire de sa capacité à évacuer la chaleur. En effet, plus la capacité thermique du circuit est faible, plus le courant maximal qui peut circuler dans l'interrupteur 3 est faible. Soit on abaisse la limite de fonctionnement en courant, c'est-à-dire le seuil du limiteur 5 pour éviter une surchauffe. Soit la protection thermique du circuit 4 entre en action plus souvent. Dans les deux cas, cela nuit au fonctionnement de la charge 1.

De plus, la fixation des seuils de courant Imax et de température $T^{th}_j$ doit répondre à des objectifs qui peuvent s'avérer contradictoires. En particulier, la limitation en courant doit être choisie la plus basse possible pour limiter l'élévation en température de l'interrupteur en cas de court-circuit dans la charge. Mais, un seuil Imax de limitation en courant trop bas peut nuire à l'allumage de la charge. En effet, à l'allumage, le courant d'appel de la charge peut être tel qu'il excède le seuil Imax. Dans un tel cas, on assiste à un allongement du temps d'allumage de la charge sous un courant restant supérieur à un courant nominal. Cela engendre un échauffement pendant une durée plus longue. Même si cet échauffement ne déclenche pas la protection thermique parce que le seuil $T^{th}_j$ a été prévu en conséquence afin de ne pas nuire à l'allumage, on assiste à une usure accélérée du circuit en raison des contraintes thermiques qu'il subit. En pratique, on observe des arrachements des fils de connexion, des décollements de la face arrière de la puce intégrant l'interrupteur 3 et/ou l'apparition de défauts dans la structure monocristalline du semiconducteur, typiquement du silicium, dans lequel est intégré l'interrupteur 3. Ces défauts peuvent en outre se révéler après une durée de fonctionnement relativement longue, donc difficilement détectable lors des tests de qualification du composant et de l'application qui l'utilise.

Si le seuil Imax de limitation en courant est prévu pour ne pas être atteint à l'allumage de la charge 1, on assiste alors à des variations thermiques de grande amplitude en cas de court-circuit.

Dans certaines charges (par exemple, des clignotants de véhicules), on doit permettre des allumages périodiques avec des temps de repos dont la courte durée ne permet pas un refroidissement suffisant du circuit. Pour permettre un fonctionnement correct, on doit alors fixer un seuil thermique élevé. Là encore, cela raccourcit la durée de vie du circuit. On pourrait penser abaisser le seuil thermique. Toutefois, cela empêcherait alors tout démarrage "à chaud" d'une charge 1. Il faudrait en effet attendre un refroidissement suffisant de l'interrupteur 3 pour remettre en route la charge. Cela interdirait même, dans le cas d'une commande en régime linéaire, un redémarrage à plus faible puissance.

Les inconvénients ci-dessus sont d'autant plus critiques que la capacité de dissipation du circuit est faible. Or, avec la miniaturisation incessante des circuits intégrés, on assiste à une diminution inévitable de la capacité thermique des circuits, donc une élévation en température plus rapide.

La présente invention vise à proposer un circuit de commande d'une charge qui pallie les inconvénients des circuits connus.

L'invention vise, plus particulièrement, à proposer un circuit de commande assurant une protection thermique efficace, sans nuire au fonctionnement des charges en régime nominal.

L'invention vise également à permettre l'utilisation d'un seuil de limitation en courant qui soit supérieur au courant d'appel des charges, sans nuire à la protection contre les courts-circuits.

L'invention vise également à proposer une solution qui supprime les problèmes de vieillissement accéléré des composants.

L'invention vise en outre à proposer un circuit compatible avec la miniaturisation et la diminution de capacité thermique qu'elle engendre.

Pour atteindre ces objets et d'autres, la présente invention prévoit un circuit de commande en alimentation d'une charge, ledit circuit comprenant un interrupteur intégré et son circuit de commande dans un même boîtier, et des moyens propres à asservir le niveau du courant traversant ledit interrupteur en fonction d'une différence de température instantanée entre l'interrupteur et son environnement.

Selon un mode de réalisation de la présente invention, ladite différence de température est mesurée au moyen d'un premier capteur intégré à l'interrupteur et d'un deuxième capteur intégré dans son circuit de commande.

Selon un mode de réalisation de la présente invention, l'interrupteur et son circuit de commande sont intégrés sur une même puce semiconductrice.

Selon un mode de réalisation de la présente invention, lesdits moyens sont constitués par un comparateur recevant des signaux représentatifs de températures de l'interrupteur et de son environnement.

Selon un mode de réalisation de la présente invention, un circuit pilote propre à fournir un signal de commande à l'interrupteur est pourvu de moyens de protection thermique modifiant la consigne de commande de l'interrupteur quand la température de celui-ci dépasse un seuil de température, lesdits moyens modifiant la valeur dudit seuil de température en fonction de ladite différence de température.

Selon un mode de réalisation de la présente invention, le circuit comprend un limiteur du courant dans l'interrupteur par rapport à un seuil de limitation, lesdits moyens modifiant la valeur dudit seuil de limitation en fonction de ladite différence de température.

Selon un mode de réalisation de la présente invention, l'asservissement est linéaire.

Selon un mode de réalisation de la présente invention, l'asservissement est en tout ou rien.

Selon un mode de réalisation de la présente invention, ledit interrupteur est fixé sur un même suscepteur que le reste dudit circuit, lesdits moyens étant propres à comparer la température dudit interrupteur et la température dudit suscepteur à proximité du reste du circuit de commande.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :

 la figure 1 décrite précédemment représente, de façon partielle et schématique, une charge de puissance associée à un circuit de commande connu ;
 la figure 2 illustre, schématiquement, la variation de température dans un interrupteur de puissance lors d'une variation de la puissance d'une charge commandée par cet interrupteur ; et
 la figure 3 représente, partiellement et schématiquement, un circuit de commande selon un mode de réalisation de la présente invention.

La présente invention tire son origine d'une nouvelle analyse du comportement en température d'un interrupteur de puissance tel qu'un transistor MOS, et du circuit qui l'intègre.

La figure 2 est un chronogramme qui illustre schématiquement la variation, au cours du temps t, des températures au sein d'une puce intégrant le circuit de commande d'une charge, au niveau de l'interrupteur de puissance $T_j$ et au niveau de son environnement proche tel que le boîtier dont la température est assimilée à celle $T_F$ du suscepteur (frame) de la puce.

On considère l'instant de mise en route de la charge comme origine (0) du temps t. On considère également qu'à l'origine le système est stable depuis un certain temps et que les températures initiales de la jonction $T_j^0$ et du suscepteur $T_F^0$ sont égales.

Lors de la variation de puissance aux bornes de la charge, avant la stabilisation au régime nominal, la température du suscepteur $T_F$ varie selon une courbe en cloche, pour atteindre une valeur $T_F^1$ légèrement supérieure à la valeur initiale $T_F^0$.

Lors de la même variation de puissance, la

température $T_j$ de l'interrupteur de puissance varie beaucoup plus fortement toujours selon une courbe en cloche. La valeur transitoire maximale $T_j^{max}$ atteinte par l'interrupteur est très supérieure à la valeur transitoire maximale $T_F^{max}$ atteinte par son environnement. Une fois le régime nominal souhaité atteint, la température $T^1$ de l'interrupteur reste généralement supérieure à celle $T_F^1$ atteinte par son environnement (différence nominale $\Delta Tnom$).

Le fonctionnement exposé ci-dessus suppose à la fois que le seuil de limitation en courant (Imax, figure 1) soit supérieur au courant d'appel de la charge et que le seuil $T^{th}$ de protection thermique soit supérieur à la température maximale $T_j^{max}$ atteinte dans le régime transitoire.

Les inventeurs considèrent que les problèmes de durée de vie de l'interrupteur de puissance indiqués précédemment apparaissent dès que l'écart de température entre le transistor MOS et son environnement proche, c'est-à-dire la différence de température $\Delta T$ entre la jonction de source du transistor et son boîtier, dépasse une valeur donnée qui dépend des seules caractéristiques de l'interrupteur de puissance, et ceci même si la température absolue $T_j$ de la jonction demeure inférieure à la température seuil $T_j^{th}$ de disjonction thermique.

On notera que l'usure accélérée provenant de variations brusques de la température de l'interrupteur est indépendante de sa température nominale de fonctionnement. Ainsi, un interrupteur de puissance peut présenter une plage de fonctionnement en température importante (par exemple, de -40°C à +150°C) et présenter, à l'intérieur de cette plage, des dysfonctionnements en cas de variations brusques de température (par exemple, correspondant à une variation de l'ordre de 100°C de la température de jonction en quelques millisecondes).

La figure 3 représente, partiellement et sous forme de blocs fonctionnels, un circuit de commande (COMMAND) 20 selon un mode de réalisation de la présente invention. Le circuit 20 est, dans l'exemple représenté, interposé entre une ligne d'alimentation haute Vcc et une première borne d'une charge de puissance 1 (Q), dont une autre borne est connectée à une ligne de référence de tension ou masse GND. Le circuit 20 comporte, en série entre l'alimentation haute Vcc et une borne de sortie OUT, un interrupteur de puissance 23, par exemple un transistor MOS, commandé par un circuit pilote (DRIV) 24. Le circuit 24 fournit un signal de commande à la grille du transistor 23.

L'interrupteur 23 peut être commandé en commutation ou en régime linéaire. Dans ce dernier cas, le circuit 24 reçoit une référence de tension Vref et la tension de sortie Vout (liaisons en pointillés).

De façon classique, le circuit 24 est également propre à modifier sa commande, c'est-à-dire ouvrir l'interrupteur 23 ou diminuer sa consigne pour diminuer le courant, si sa température interne $T_j$ dépasse un seuil prédéterminé $T^{th}_j$.

Le circuit de commande 20 comporte également un limiteur de courant (LIM) 25, connecté entre la borne de sortie OUT et la ligne de commande de l'interrupteur 23. De façon classique, le limiteur 25 a pour objet de limiter la différence de potentiel grille-source du transistor 23, donc le courant, pour protéger contre les courts-circuits. Toutefois, selon l'invention, le courant limite Imax est fixé à une valeur supérieure à la valeur du courant d'appel maximal de la charge à l'allumage (ou en changement de régime).

Selon la présente invention, le circuit 20 comporte également un circuit 26 ($\Delta T$) de contrôle de différence de température, propre à évaluer l'écart de température instantané $\Delta T$ entre le transistor 23 et son environnement proche. Il s'agit en fait de la température du boîtier, assimilée à celle $T_F$ du suscepteur sur lequel est rapportée la puce de circuit intégré comprenant le circuit de commande 20. Un capteur de température ($T_F$) 27 est prévu dans une partie de la puce intégrant le circuit de commande 20 (de préférence, dans le circuit de commande lui-même), choisie de préférence pour être la plus éloignée possible de l'interrupteur 23. A titre d'exemple particulier, le capteur de température 27 est une jonction PN (par exemple, une diode, un transistor bipolaire, etc.) dont le seuil de conduction varie en fonction de la température. Côté interrupteur 23, la température est également mesurée, de façon classique, en utilisant une des jonctions du transistor.

L'invention s'applique plus particulièrement au cas où le circuit de commande 20 et l'interrupteur de puissance 23 sont intégrés dans un même circuit, et sera décrite par la suite en relation avec cette application. Toutefois, elle s'applique plus généralement dès que le circuit de commande et l'interrupteur, même sur des puces distinctes, sont dans un même boîtier ou portés par un même suscepteur.

Le circuit 26 est, par exemple, un comparateur recevant, en entrée, des signaux représentatifs des températures de l'interrupteur $T_j$ et de son environnement $T_F$. Le signal de sortie du circuit 26 est fourni au circuit 24 et au limiteur 25. En variante, un seul des circuits 24 et 25 reçoit le signal de sortie du circuit 26.

Selon un mode de réalisation préféré, le circuit 26 fournit un signal de sortie (analogique) $\Delta T$ modifiant dynamiquement le seuil de température de la protection thermique du circuit 24 et/ou le seuil d'activation du limiteur de courant 25. Cette modification n'intervient cependant qu'à partir d'un seuil $\Delta Tref$ choisi pour être supérieur à l'écart nominal $\Delta Tnom$ (figure 2) maximal acceptable et, de préférence, supérieur à l'écart au démarrage de la charge.

Selon un autre mode de réalisation, le circuit 26 fournit un signal de sortie (numérique) qui présente un premier état tant que la valeur courante de la différence de température $\Delta T$ est inférieure à une valeur maximale $\Delta Tmax$. Le signal de sortie prend un second état, différent du premier, dès que la valeur courante de la différence de température $\Delta T$ atteint la valeur maximale $\Delta Tmax$. Le signal de sortie du circuit 26 retourne au premier état dès que la valeur courante $\Delta T$ redevient égale ou inférieure à une valeur de référence $\Delta Tref$ (choisie, par exemple, comme pour le mode de réalisation préféré), inférieure à la valeur maximale $\Delta Tmax$. Le circuit 26 est, par exemple, un comparateur à hystérésis. On assiste alors, tant que l'écart de température reste supérieur à $\Delta Tref$, à un hachage du courant I dans l'interrupteur 23.

Un avantage du contrôle de différence de température au voisinage de l'interrupteur 23, opéré par l'invention, est que cela évite les dysfonctionnements des circuits connus.

En particulier, on évite les compromis préjudiciables dans le dimensionnement des seuils de courant Imax et de température absolue $T_j^{th}$.

Notamment, l'invention permet de rendre le choix de la valeur Imax de la limitation de courant indépendante des risques d'échauffement d'un interrupteur de puissance particulier, mais fonction uniquement des caractéristiques de tenue en courant des fils de liaison entre les différentes bornes, pour se concentrer sur la protection contre les courts-circuits. La présente invention permet donc de fixer un courant de limitation $I_{max}$ plus élevé que dans le cas des circuits connus.

Grâce à cela, le circuit de commande de l'invention ne provoque pas d'allongement du temps de démarrage d'une charge en autorisant un seuil Imax de protection contre les courts-circuits qui est supérieur au courant d'appel normal. Par contre, en cas d'augmentation brutale du courant liée à un court-circuit, l'échauffement rapide auquel on assiste provoque le déclenchement du circuit de protection contre les écarts de température de l'invention, ce qui limite bien le courant dans l'interrupteur.

Un autre avantage de l'invention est qu'elle permet les démarrages à chaud. En effet, le seuil absolu de température $T_j^{th}$ est désormais fixé à une valeur supérieure par rapport à la valeur choisie par compromis dans le cas classique. Par conséquent, tant que le démarrage est compatible avec les seuils d'écart $\Delta Tref$, de température absolue $T_j^{th}$ et de courant Imax, la charge peut démarrer à chaud.

Les modifications apportées selon l'invention se situent uniquement dans la partie logique du circuit de commande. En effet, l'interrupteur de puissance n'est pas modifié par rapport à un circuit connu. Le gain de fiabilité de fonctionnement de l'interrupteur compense largement la surface de semiconducteur nécessaire pour intégrer les différentes fonctions décrites précédemment.

Bien entendu, la présente invention est susceptible de diverses variantes et modifications qui apparaîtront à l'homme de l'art.

En particulier, la réalisation pratique des différents constituants d'un circuit de commande selon l'invention est à la portée de l'homme du métier à partir des indications fonctionnelles données ci-dessus. De même, l'invention s'applique aussi bien à une configuration où la charge est reliée directement à la ligne d'alimentation haute Vcc qu'à la configuration représentée où elle est reliée à la masse.

De plus, la détermination des seuils $\Delta Tmax$, $\Delta Tref$, Imax, et $T_j^{th}$ dépend de l'application et est également à la portée de l'homme du métier. Par exemple, dans le cas d'un interrupteur de puissance de type transistor MOS, la valeur de référence $\Delta Tref$ sera comprise entre 30 et 100°C.

En outre, toute autre configuration de différence de température est envisageable. Par exemple, les températures initiales de l'interrupteur et de son boîtier peuvent être différentes l'une de l'autre et leurs températures finales pourraient être égales. La température finale de l'un ou l'autre des deux éléments - boîtier et interrupteur - peut être égale à sa température initiale.

Enfin, l'interrupteur de puissance pourra être de n'importe quel type, par exemple, un transistor bipolaire, un thyristor ou encore un triac.

**Revendications**

1. Circuit (20) de commande en alimentation d'une charge (1), ledit circuit comprenant un interrupteur intégré (23) et son circuit de commande dans un même boîtier, **caractérisé en ce qu'**il comprend des moyens (26) propres à asservir le niveau du courant traversant ledit interrupteur en fonction d'une différence de température instantanée ($\Delta T$) entre l'interrupteur et son environnement.

2. Circuit selon la revendication 1, **caractérisé en ce que** ladite différence de température ($\Delta T$) est mesurée au moyen d'un premier capteur intégré à l'interrupteur (23) et d'un deuxième capteur (27) intégré dans son circuit de commande.

3. Circuit selon la revendication 1 ou 2, **caractérisé en ce que** l'interrupteur (23) et son circuit de commande sont intégrés sur une même puce semiconductrice.

4. Circuit selon l'une quelconque des revendications 1 à 3, **caractérisé en ce que** lesdits moyens (26) sont constitués par un comparateur recevant des signaux représentatifs de températures de l'interrupteur ($T_j$) et de son environnement ($T_F$).

5. Circuit selon l'une quelconque des revendications 1 à 4, comprenant un circuit pilote (24) propre à fournir un signal de commande à l'interrupteur (23), ledit circuit pilote étant pourvu de moyens de protection thermique modifiant la consigne de commande de l'interrupteur quand la température ($T_j$) de celui-ci dépasse un seuil de température ($T_j^{th}$),

**caractérisé en ce que** lesdits moyens (26) modifient la valeur dudit seuil de température en fonction de ladite différence de température ($\Delta T$).

6. Circuit selon l'une quelconque des revendications 1 à 5, comprenant un limiteur (25) du courant dans l'interrupteur (23) par rapport à un seuil de limitation (Imax), **caractérisé en ce que** lesdits moyens modifient la valeur dudit seuil de limitation en fonction de ladite différence de température ($\Delta T$).

7. Circuit selon l'une quelconque des revendications 1 à 6, **caractérisé en ce que** l'asservissement est linéaire.

8. Circuit selon l'une quelconque des revendications 1 à 6, **caractérisé en ce que** l'asservissement est en tout ou rien.

9. Circuit selon l'une quelconque des revendications 1 à 8, **caractérisé en ce que** ledit interrupteur (23) est fixé sur un même suscepteur que le reste dudit circuit (20), et **en ce que** lesdits moyens (26) sont propres à comparer la température ($T_j$) dudit interrupteur et la température ($T_F$) dudit suscepteur à proximité du reste du circuit de commande.

Fig 1

Fig 2

Fig 3

**Office européen
des brevets**

## RAPPORT DE RECHERCHE EUROPEENNE

Numéro de la demande

EP 03 35 4026

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | DATABASE WPI<br>Week 200308, 21 mars 2002 (2002-03-21)<br>Derwent Publications Ltd., London, GB;<br>AN 2002-681904<br>XP002234062<br>& TW 480 815 B (ANALOG INTEGRATIONS CORP)<br>* abrégé *<br>--- | 1-9 | H03K17/08 |
| X | EP 0 740 491 A (CONS RIC MICROELETTRONICA ;SGS THOMSON MICROELECTRONICS (IT))<br>30 octobre 1996 (1996-10-30) | 1 | |
| A | * le document en entier *<br>--- | 2-9 | |
| X | EP 1 162 723 A (ST MICROELECTRONICS SRL)<br>12 décembre 2001 (2001-12-12) | 1 | |
| A | * le document en entier *<br>----- | 2-9 | |

DOMAINES TECHNIQUES
RECHERCHES (Int.Cl.7)

H03K
G05F
H05B

Le présent rapport a été établi pour toutes les revendications

| Lieu de la recherche | Date d'achèvement de la recherche | Examinateur |
|---|---|---|
| LA HAYE | 25 septembre 2003 | Schobert, D |

CATEGORIE DES DOCUMENTS CITES

X : particulièrement pertinent à lui seul
Y : particulièrement pertinent en combinaison avec un
autre document de la même catégorie
A : arrière-plan technologique
O : divulgation non-écrite
P : document intercalaire

T : théorie ou principe à la base de l'invention
E : document de brevet antérieur, mais publié à la
date de dépôt ou après cette date
D : cité dans la demande
L : cité pour d'autres raisons

......................................................................
& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 03 35 4026

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

25-09-2003

| Document brevet cité au rapport de recherche | | Date de publication | Membre(s) de la famille de brevet(s) | | Date de publication |
|---|---|---|---|---|---|
| TW 480815 | B | 21-03-2002 | US | 2002097541 A1 | 25-07-2002 |
| EP 0740491 | A | 30-10-1996 | EP | 0740491 A1 | 30-10-1996 |
| | | | CN | 1138285 A | 18-12-1996 |
| | | | US | 6051933 A | 18-04-2000 |
| EP 1162723 | A | 12-12-2001 | EP | 1162723 A1 | 12-12-2001 |
| | | | US | 2001050855 A1 | 13-12-2001 |

EPO FORM P0460

Pour tout renseignement concernant cette annexe : voir Journal Officiel de l'Office européen des brevets, No.12/82